# EUROPEAN PATENT SPECIFICATION

(11) **EP 2 737 521 B1**
(45) Date of publication and mention of the grant of the patent: **15.06.2016**
(21) Application number: 12747990.5
(22) Date of filing: 25.07.2012
(51) Int. Cl.: H01L 21/20

(54) **MANUFACTURING OF WAFERS OF WIDE ENERGY GAP SEMICONDUCTOR MATERIAL FOR THE INTEGRATION OF ELECTRONIC AND/OR OPTICAL AND/OR OPTOELECTRONIC DEVICES**
HERSTELLUNG VON WAFERN AUS EINEM HALBLEITERMATERIAL MIT BREITER ENERGIELÜCKE ZUR INTEGRATION ELEKTRONISCHER UND/ODER OPTISCHER UND/ODER OPTOELEKTRONISCHER VORRICHTUNGEN
FABRICATION DE TRANCHES OF MATÉRIAU SEMICONDUCTEUR À LARGE BANDE INTERDITE POUR L'INTÉGRATION DE DISPOSITIFS ÉLECTRONIQUES, OPTIQUES ET / OU OPTOÉLECTRONIQUES

(30) Priority: 28.07.2011 IT MI20111421
(43) Date of publication of application: 04.06.2014
(73) Proprietor: Consiglio Nazionale Delle Ricerche, 00185 Roma (IT)
(72) Inventor: CAMARDA, Massimo, I-00185 Roma (IT); SEVERINO, Andrea, I-00185 Roma (IT); LA VIA, Francesco, I-00185 Roma (IT)
(74) Representative: Maccalli, Marco
(86) International application number: PCT/EP2012/064602
(87) International publication number: WO 2013/014188

(56) References cited:
- US-A1- 2003 132 433
- US-A1- 2007 178 676
- US-A1- 2008 173 895
- ZHANG C ET AL: "Characteristics of beta-SiC/Si heterojunction with a SiGe buffer film", MICROELECTRONICS JOURNAL, MACKINTOSH PUBLICATIONS LTD. LUTON, GB, vol. 39, no. 8, 1 August 2008 (2008-08-01) , pages 1080-1082, XP022822884, ISSN: 0026-2692, DOI: 10.1016/J.MEJO.2008.01.044 [retrieved on 2008-05-09] cited in the application

## Description

### DESCRIPTION

### Background of the invention

In the field of power electronics, in recent decades there has been a substantial increase in the consumption of electric power, reaching values of annual consumption of the order of tens of thousands of TWh.

The use of innovative materials for the construction of electronic devices used in power applications, such as wide energy bandgap semiconductors would enable the reduction of such consumption, since electronic devices based on wide energy gap semiconductors (such as silicon carbide - SiC - and gallium nitride - GaN -, having energy gap greater than 2 eV, compared to 1.12 eV of silicon - Si) are more efficient and are characterized by their small losses (power loss). In particular, unipolar field effect transistors based on metal-oxide-semiconductor contacts (the known Metal Oxide Semiconductor Field Effect Transistors or MOSFETs) made of SiC are considered the ideal kind of electronic device and the most efficient way to overcome the drawbacks of actual electronic devices used in the context of power electronics, namely Insulated Gate Bipolar Transistors (IGBTs), manufactured in Si. This would allow to have power electronic devices operating up to 3,000 V with a specific on-state resistance similar to that of MOSFETs in Si operating at 300 V, a very attractive feature in applications requiring high switching speed and low switching losses.

In particular, a strong demand for such power electronic devices is in the field of the generation of sustainable and renewable energy, because power electronic devices in SiC are required as inverters in photovoltaic applications and as converter in wind turbines. Moreover, the further development of these technologies is strongly demanded by the automotive industry in view of the development and sale of hybrid electric cars (Hybrid Electric Vehicles, HEV), which is forecasted in case of success in reducing the cost of high power devices in SiC operating up to 2 kV.

Nowadays, the most important limitations reside in the cost/part for each chip produced in SiC and in the limited production of microelectronic devices. According to some market research in the field of PFC (Power Factor Corrector) modules, devices operating at 600 V with current rating between 4 and 8 A, the impact of electronic devices based on innovative materials such as SiC and GaN would allow a shrink of size, linked to a higher operating frequency with a consequent reduction in the size of components passive, and a stability over a temperature range wider than current devices in Si. The cost of every single chip, however, would increase due to the high costs of production of a bulk of SiC.

As known, SiC can take many crystal forms. The polymorphism of SiC is characterized by a large family of crystalline structures similar to each other, called polytypes: these are essentially variants of the same chemical compound that have the same crystal structure in two spatial directions and differ in the third spatial direction. The on polytype of the SiC, having an hexagonal crystal structure (4H-SiC or 6H-SiC), is the most frequent. Another polytype is the β, having cubic crystal structure (3C-SiC). The polytype 3C-SiC, compared to the α polytype, is better suited for the use in the manufacture of electronic devices, having superior physical properties. For example, the polytype 3C-SiC features, compared to the hexagonal polytype 4H-SiC, a large area and reduced costs, and has a higher channel electron mobility. This requirement is particularly important for the realization of commercially competitive power MOSFETs. At present, in fact, the technology based on the omoepitaxy of 4H-SiC shows limits, other than in terms of cost, in the morphologies of the surface of the epitaxial layers, preventing the realization of marketable power MOSFETs; currently, the market for electronic devices in 4H- SiC is limited to the production of Schottky diodes operating at 600 V with a current rating between 6 and 10 A.

The realization of 3C-SiC substrates of large area on economic starting substrates in Si is therefore strongly required.

The main reason that hinders the development of sustainable large-scale technology based on the etero-epitaxy SiC/Si lies in the lattice mismatch between the two materials. The same problem is also encountered with other innovative wide energy gap semiconductor materials such as GaN and diamond.

Such a lattice mismatch between the starting substrate in Si and the material grown epitaxially thereon causes a strain which causes the warping of the entire wafer of semiconductor material (a so-called wafer bow phenomenon) making inapplicable subsequent process steps such as the lithography, the mechanical cleaning and the like, necessary for the realization of electronic devices by means of the known planar technology.

The generated strain produces a stress within the epitaxial layer (film), strongly influencing the material's physical properties and performance of devices made from it. The lattice mismatches between the two materials (Si substrate and epitaxial layer of SiC, GaN, or diamond) generate crystal defects that are classified as Misfit Dislocations (MDs), Stacking Faults (SFs), twins (MTs), Anti-Phase Domains (APDs), hillocks and voids.

For the most part, the experiments of epitaxial growth of 3C-SiC on Si have been conducted by means of Chemical Vapor Deposition - CVD - with the use of a broad spectrum of gaseous precursors of carbon and silicon. In S. Nishino, J. A. Powell, and H. A. Will, Appl. Phys. Lett 42, 460 (1983) it is reported a CVD process in more steps which consists of different stages of growth. Firstly, a thin buffer layer of SiC is formed by using the direct conversion of the Si into SiC under the action of a hydrocarbon gas. Subsequently, the crystal growth is performed by means of flows of gaseous precursors of Si and C at temperatures near the melting temperature of the Si. In these conditions, a film of single crystal 3C-SiC can be grown on the Si. Unfortunately, however, the crystallographic quality is not high enough to allow a serious development of devices based on 3C-SiC/Si.

To overcome these limitations, some modified substrates have been developed, called "compliant substrates". The basic concept of a "compliant substrate" is to manipulate the starting seed to make it more suitable for the subsequent deposition of a material with high lattice mismatch, as in the case of the 3C-SiC epitaxy on Si substrates Several examples of compliant substrates can be found in the literature: among these, it has been reported the growth of thin films of 3C-SiC of reasonable quality on Silicon On Insulator (SOI). In this case, the SiO2 acts as a barrier against the diffusion of Si, reducing the formation of voids at the interface, while the thin layer of Si appears to be essential, playing the role of the crystal seed for the subsequent growth of 3C-SiC. In addition, the residual stress in the layer of SiC is reduced thanks to the softening of the oxide, close to its melting temperature. However, the growth of 3C-SiC on SOI is hampered by the poor thermal stability of the thin layer of Si and by the reduced thermal budget of the oxide.

Another interesting alternative is the use of porous silicon (p-Si). Some studies have demonstrated an improved ability to relax the residual stress of the 3C-SiC layer grown on p-Si compared to SOI substrates. However, layers of 3C-SiC on p-Si exhibit a high interfacial and surface roughness, of more than one micron, which limits their use for subsequent process steps necessary for the realization of electronic devices and/or sensors. Together with porous Si, silicon substrates with a cavity layer immediately below the surface layer (Silicon on nothing) have been used as a possible structure of relaxation of stress induced by the epitaxial growth process. The most important result in the growth of heteroepitaxial 3C-SiC on compliant substrates has been reached on undulating Si, very effective in reducing planar defects that propagate through the layer of 3C-SiC but not for the reduction of the wafer bow. Using this technique, prototypes have been made of MOS field effect transistors (MOSFETs) with sufficiently good electrical performance.

In C. Zhang, S. Liu, "Characteristics of β-SiC/Si SiGe heterojunction with a buffer film", published in Microelectronics Journal 39 (2008) p. 1080-1082, the authors describe the preparation of a thin buffer layer of SiGe of thickness of 0.1 to 0.2 µm with 20% Ge concentration on a wafer of single crystal p-type doped Si, and on the layer of SiGe is then grown an epitaxial layer of undoped β-SiC, by LPCVD (Low Press Chemical Vapour Deposition). On both sides of the structure ohmic contacts in aluminum (Al) are finally formed, to produce a β-SiC/SiGe/P-Si heterojunction Schottky diode. According to the authors of the article, the introduction of the buffer layer in SiGe can improve the interface properties of the heterojunction, the reverse breakdown voltage of the Schottky diode and the rectifying ratio of the heterojunction.

Likewise, patent documents US 20030132433, US 2007 0178676 and US20080173895 all disclose the use of SiGe buffer layers for the epitaxial growth of high-bandgap (e.g.. SiC, GaN) semiconductors on silicon.

In O.M. Alatise et al, "The Impact of self-heating and strain-relaxed SiGe buffer thickness on the analog performance of strained Si nMOSFETs", published in Solid-State Electronics 54 (2010) p. 327-335, there are investigated the properties of MOSFETs manufactured in wafers consisting of a substrate in Si, a "relaxed" layer of SiGe, and, above the SiGe layer, a thin layer of strained Si that constitutes the channel of the MOSFETs.

### Summary of the invention

In view of the state of the art just described, the Applicant has tackled the problem of devising a method that would allow to avoid the problems encountered in the epitaxial growth, on starting substrates of Si, of layers of significant thickness, sufficient to act in turn as a substrate for the integration of electronic and/or optical and/or optoelectronic devices, semiconductor materials having a wide energy gap, such as SiC, GaN or diamond, having a crystalline structure that exhibits a mismatch with that of the Si lattice.

The Applicant has realized that through a more accurate control of the formation of dislocations at the interface (misfit dislocations) it is possible to grow, on starting substrates in Si, epitaxial layers of semiconductor materials having lattice parameter (as known, the lattice parameter is the constant value that defines the distance between unitary cells in a crystal lattice) different from that of Si, such as wide energy gap semiconductor materials, featuring a high crystallographic quality with an extremely reduced residual stress.

Starting from this intuition, the Applicant has found that this control can be achieved by forming, on the starting substrate in Si, a buffer layer of Si1-xGex alloy of Si and Ge), which buffer layer, initially deposited on the starting substrate in strained Si (i.e. with a compressive strain, in the case of a perfect epitaxy, that is in perfect lattice match, with the Si crystal lattice), can properly relax, both during the same process of growth and possibly as a result of controlled thermal processes, in order to optimize the lattice mismatch of the entire heteroepitaxial system Y/Si₁₋ₓGeₓ/Si, where Y denotes the wide energy gap semiconductor that has to be grown, for example, SiC, GaN, diamond.

The buffer layer of Si₁₋ₓGeₓ epitaxially grown on the starting substrate in Si allows to keep under control the formation of crystal defects at the interface (misfit dislocations) in the heteroepitaxies characterized by high crystallographic mismatch, thereby making it possible to reduce the deformations (strain) and stress generated by the heterostructure and improving the crystallographic quality of the subsequently grown layer of wide energy gap semiconductor material.

In particular, the buffer layer, through a suitable choice of the concentration of Ge and the thickness of the buffer layer itself, allows to obtain a lattice parameter effective for the control of the strain generated by the subsequent epitaxial growth of the desired wide energy gap semiconductor.

On this buffer layer, which results to be in a relaxed condition with respect to the underlying Si substrate, a thin layer of strained Si is then deposited, i.e. a thin layer of Si that adapts its own reticular pitch to that of the buffer layer below. This thin layer of metastable pseudomorphic Si acts as an ideal crystal seed for the subsequent epitaxial growth of the layer of wide energy gap semiconductor, in particular SiC, GaN, diamond.

The starting substrate in Si with superimposed thereon the buffer layer of SiGe, and, the thin layer of Si superimposed on the SiGe layer, forms a "virtual substrate" on which the wide energy gap semiconductor layer can be grown.

According to an aspect of the present invention, a method is provided for the manufacture of a wafer of semiconductor material to be used for the integration of electronic and/or optical and/or optoelectronic devices, particularly but not exclusively power electronic devices, such as power MOSFETs, photodetectors, optoelectronic modulators, passive and/or active waveguides and the like.

The method is defined in the appended independent method claim; optional features, not considered essential, are defined in the dependent method claims.

According to another aspect of the present invention there is provided a wafer of semiconductor material to be used for the integration of electronic and/or optical and/or optoelectronic devices, particularly but not exclusively power electronic devices, such as power MOSFETs, photodetectors , optoelectronic modulators, passive and/or active waveguides and the like, as defined in the appended independent wafer claim.

### Brief description of the drawings

These and other features and advantages of the present invention will become apparent from the following detailed description of embodiments thereof, which description is provided purely by way of non-limiting example and will be conducted by referring to the drawings (not to scale), in which:
Figures **1A** and **1B** show schematically two steps of a process of manufacturing a wafer of semiconductor material comprising an Si substrate and, superimposed to the substrate, a layer of a wide energy gap semiconductor, such as SiC, which involves the problems discussed previously;
Figures 2A - 2D schematically show some steps of a method of manufacturing a wafer of semiconductor material according to an embodiment of the present invention, which provides for the formation of a buffer layer of SiGe; and
Figure 3 shows curves of possible concentrations of Ge in the SiGe buffer layer.

### Detailed description of exemplary embodiments of the invention

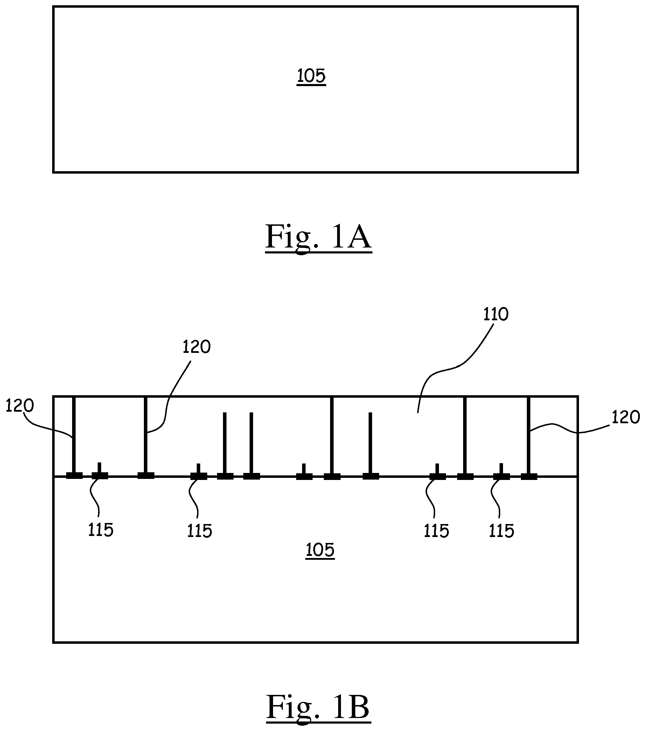

With reference to the drawings, and in particular to **Figures 1A** and **1B****,** when on a wafer in Si 105 there is directly epitaxially grown a layer 110 of a wide energy gap semiconductor material, such as SiC, GaN, diamond, which has a crystalline structure with relatively high lattice mismatch compared to the underlying crystal of Si 105, there are formed, typically in an uncontrolled and unstable way, interface dislocations 115 (misfit dislocations) between the two crystals, which, because of this instability, can also propagate within the layer in SiC **110** forming so-called threading dislocations **120.** The threading dislocations **120** significantly worsen the quality of the SiC crystal **110** and generate stress in the layer **110,** compromising the features and performance of electronic devices that should later be integrated into the SiC layer **110.**

In particular, considering the heteroepitaxy SiC/Si, which is characterized by a mismatch of 19.72 % between the lattice of the Si and SiC crystals, a lattice match between 5 crystal cells of the SiC crystal and 4 crystal cells of the Si crystal can be achieved by the introduction of a two-dimensional array of misfit dislocations at (parallel to) the interface between the two materials. The lattice match which is attained in this way is still imperfect, because there is a residual mismatch of 0.3 %, and the residual mismatch, although much lower than the initial 19.72 %, generates a residual stress in the layer of SiC **110,** giving rise to deformations (warping) in the overall wafer structure (wafer bow), together with an inherent instability of the matrix of dislocations which for this reason tend to become non-parallel dislocations at the interface (i.e., threading dislocations), which, by propagating into the layer of SiC **110,** reduce the crystalline quality and modify the electrical and mechanical properties of the layer of SiC itself.

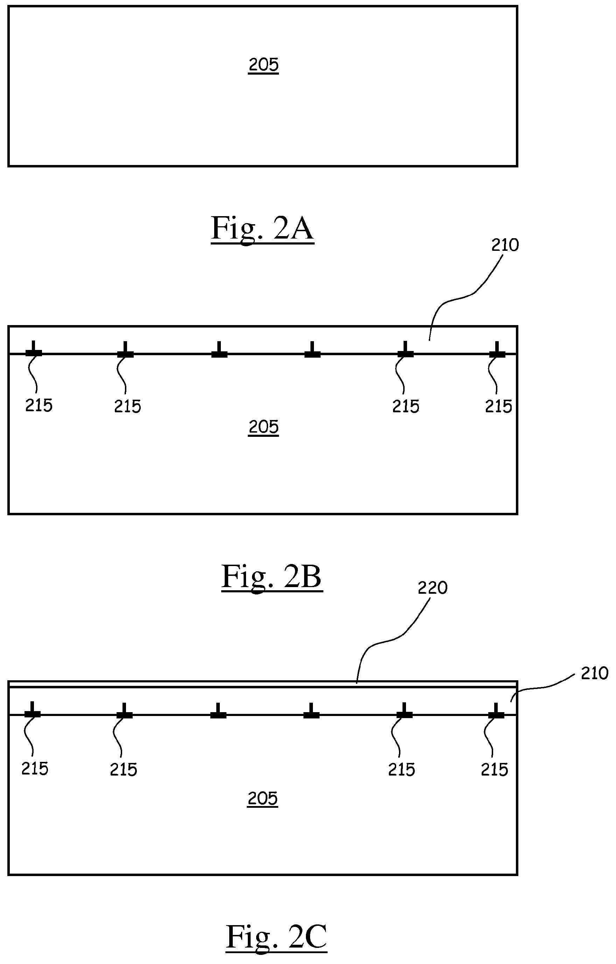

According to an embodiment of the present invention, to overcome this problem, it is proposed a method as shown schematically in **Figures 2A - 2D****.**

Still starting from a wafer in Si **205 (****Figure 2A****),** obtained according to the conventional and well-established techniques, there is epitaxially grown thereon a buffer layer **210** of Si₁₋ₓGeₓ, a alloy of Si and Ge **(****Figure 2B****).**

The adopted epitaxial growth technique can be for example the Molecular Beam Epitaxy (MBE). Other epitaxial growth techniques are also possible, such as the Chemical Vapor Deposition (CVD), the Plasma Enhanced CVD, the Physical Vapor Transport (PVT) etc.

The concentrations of Si and Ge in the alloy Si₁₋ₓGeₓ, and in particular the concentration of Ge, affect the pitch of the crystal lattice of the buffer layer **210.** Thanks to the fact that in the epitaxial growth of the buffer layer **210** it is possible to control with relatively high precision the concentration of Ge, it is consequently possible to precisely control the lattice pitch of the buffer layer **210** being grown.

According to the present invention, the concentration of Ge in the buffer layer **210** is chosen so as to substantially "tune" the lattice pitch of the buffer layer **210** with that of the underlying Si substrate **205,** so that the buffer layer **210** is substantially undeformed, or as least as possible deformed (i.e. essentially "relaxed", "unstrained").

Therefore, by properly selecting and controlling the concentration of Ge in the buffer layer **210,** it is possible to control the generation of dislocations at the interface (misfit dislocations) **215** between the buffer layer **210** and the substrate **205.** Then, by suitably choosing the thickness of the buffer layer **210,** it is possible to substantially maintain the dislocations at the interface, preventing the formation of threaded dislocations in the buffer layer **210.**

Later on in this description, exemplary values of the concentration of Ge and thickness of the buffer layer **210** that the Applicant has identified as preferable or at least suitable to achieve the purposes of the present invention will be provided.

On the buffer layer **210** there is grown a relatively thin cover layer (cap layer) in Si **220 (****Figure 2C****).** As for the growth of the buffer layer **210,** also for the growth of the cap layer **220** MBE, or other known epitaxial growth techniques may for example be used.

The cap layer in Si **220** which is obtained is a metastable pseudomorphic layer which is deformed (strained), because its crystal lattice matches the lattice parameter of the underlying buffer layer **210.**

The provision of the Si cap layer **220** is convenient in the case where the layer of wide energy gap semiconductor material that will be subsequently grown is a layer of SiC.

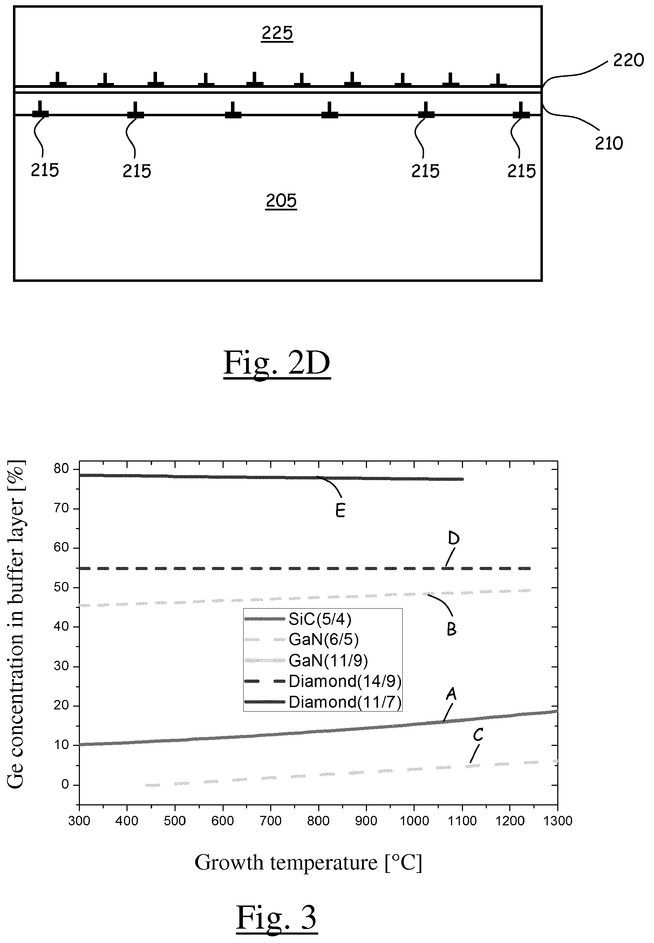

The cap layer in Si **220** acts as a crystal seed for the subsequent epitaxial growth of a wide energy gap semiconductor layer **225 (****Figure 2D****),** such as SiC, GaN, diamond.

The lattice mismatch between the layer **225** and the substrate **205** in Si varies with the temperature used for the process of epitaxial growth of the layer **225** itself. It is therefore appropriate to carefully choose the percentage of Ge in the buffer layer **210** in order to optimize the subsequent deposition of the layer **225,** taking into account the upper limit imposed by the lowering of the temperature at which the material begins to melt.

The epitaxial layer of crystalline SiC **225** can be grown using different techniques. When using CVD reactors that exploit the presence of a reactive plasma to decompose the Si and C precursors, the growth process takes place at reduced temperatures in the range between 200 °C and 800 °C. A reduced deposition temperature requires the introduction of a buffer layer in SiGe **210** from having a reduced Ge content, in order to maintain the desired 5:4 ratio between the lattice pitches of the two crystals. When using hot-wall CVD reactors with gaseous precursors, the temperature range for growth of SiC varies between 1100 °C and 1300 °C (upper limit imposed by the presence of the buffer layer of SiGe).

In **Figure 3** there are shown curves illustrating, for some of the materials which can be chosen to form the wide energy gap semiconductor layer **225,** possible concentrations of Ge in the buffer layer **210** (on the ordinate, expressed in terms of % of Ge) as a function of the temperature at which the epitaxial growth is conducted (in abscissa, expressed in °C) of the wide energy gap semiconductor layer **225.** In particular:
- curve **A** in solid line refers to the case of SiC with lattice match between 5 crystal cells of SiC and 4 crystal cells of Si;
- curve **B** in dashed line refers to the case of GaN, with lattice match between 6 cells of GaN and 5 cells of Si;
- curve **C** in dashed line still refers to the case of GaN, with lattice match of 11 cells of GaN with 9 cells of Si;
- curve **D** in dashed line refers to the case of diamond, with lattice match between 14 diamond cells and 9 Si cells, and
- curve **E** in solid line refers again to the case of diamond, with lattice matching of 11 diamond cells and 7 Si cells.

The table below reports possible suitable values of concentration of Ge in the buffer layer **210,** for the different materials that are used to form the layer **225,** indicated in the first column of the table. The expansion of the system can be "controlled" by the material of the substrate **205,** i.e. by Si, or by the material of the buffer layer **210,** i.e. SiGe. By "controlling" the expansion it is meant that the SiGe/Si system expands according to the expansion coefficients of Si or SiGe. During the ramp-shaped change in temperature, the SiGe/Si system expands/contracts according to a "real" expansion coefficient intermediate between that dictated by Si and that dictated by SiGe. The values reported in the second column of the table refer to the extreme case in which the expansion of the system is "driven" by SiGe, not by the Si substrate; the values reported in the third column of the table refer instead to the other extreme case in which the expansion of the system is not "driven" by SiGe, rather by the Si substrate, which in fact is more likely.

In general, the growth temperature will depend on the epitaxial growth process used (MBE, CVD, plasma enhanced CVD, PVT, etc..), taking into account the melting temperature of SiGe (lower than that of Si, SiC, GaN, diamond). A possible range of temperatures is from 300 to 1300 °C.

| Material | Expansion controlled by SiGe | Expansion controlled by Si |
|---|---|---|
| SiC(5/4) | ∼10-19 % | ∼10-20% |
| GaN(6/5) | ∼1-6 % | ∼2-7% |
| GaN(11/9) | ∼45-50 % | ∼46-53% |
| Diamond(14/9) | ∼77-78 % | ∼79-83% |
| Diamond(11/7) | ∼53-55 % | ∼55-59% |

The concentration of Ge in the buffer layer **210** could also not be constant, but vary (from zero to one of the values reported in the table), not to create an unstable interface between the Si substrate and SiGe.

Concerning the thickness of the buffer layer **210,** it is preferably close to the so-called "critical thickness", i.e. the thickness above which there is a relaxation of the SiGe through the creation of dislocations. The critical thickness is strongly affected by the concentration of Ge, as explained in the D.R. Leadley et. al. "Analysis of hole mobility and strain in a Si/Si_{0.5}Ge_{0.5}/Si metal oxide semiconductor field effect transistor", published in Semiconductor Science Technology 17 708 (2002). In particular, since there is not a single universally accepted theory adapted to correctly describe all the experimental results, in the literature three different models have been proposed that describe the behavior of the critical thickness: the "People & Bean" model (People R. and Bean J.C., 1985, Appl. Phys. Lett 47 322), the "Fischer, Richter & Osten" model (A. Fischer, H. Richter and H.J. Osten, 1994, Phys. Rev. Lett 73 2712) and the " Matthews-Blakeslee" model. In turn, as explained above, the concentration of Ge depends on the material that will be grown afterwards, but in general the critical thickness increases with a decrease in the percentage of Ge. Taking into account the values of the concentration of Ge in the table above, since the value of the critical thickness of the buffer layer 210 is highly dependent on many variables that influence the growth of the SiGe layer, it is advisable to maintain the thickness of the buffer layer within a relatively wide range, for example between about 0.1 and 10 µm, or preferably within about 0.5 and 5 µm.

Considering by way of example the case of a layer **225** in SiC, an appropriate value of concentration of Ge in the buffer layer **210** is between 10 % and 20 % and the thickness of the buffer layer is about 500 nm. With these values it is possible to adapt the lattice parameter to a mismatch of about 20 %, with a perfect ratio 5aSiC/4aSiGe = 1, thereby making it possible the control over the residual strain generated within the film of SiC and the generation of misfit dislocations. The Si cap layer **220,** deformed on the lattice parameter of the underlying SiGe, may have a thickness not exceeding 10 nm, useful for the conversion of the substrate surface in SiC.

The wafer obtained by the method described above is adapted to be used for the integration of electronic and/or optical and/or optoelectronic devices in the layer of wide energy gap semiconductor **225;** in particular, it is possible to integrate power electronic devices, such as MOSFET, photodetectors, optoelectronic modulators, passive and/or active waveguides and the like.

In summary then, according to an embodiment of the present invention, the insertion of a suitable buffer layer of SiGe allows to eliminate the lattice mismatch that exists between the Si substrate and the wide energy gap semiconductor layer, obtaining a perfect matching between, e.g., the five crystal cells of SiC and the four crystal cells of SiGe (and the same holds true for the other materials). This allows to make more stable and controlled the generation of misfit dislocations at the interface SiC/SiGe, thus reducing the impact of these defects on the physical properties of the epitaxially grown material. In addition, an overall beneficial effect on the wafer bow of the heterostructure is attained.

Another possibility, always obtainable through a suitable choice of the concentration of Ge in the buffer layer **210** and its thickness, is to over-compensate the residual lattice mismatch so as to invert the layer of stress of the epitaxial film, obtaining in this way a localization of the fields of stress in the system within the buffer layer **210,** and thus contributing to a further reduction of the bow of the entire wafer. In fact, the buffer layer of SiGe **210** might not be able to eliminate all the stress of the system, because another component of stress of the system is related to the thermal stress, which acts during the cooling phase after the growth process. It could therefore be possible to not aim at a perfect match between the lattice parameters of the epitaxial buffer layer in the SiGe **210** and the underlying Si substrate **200,** by increasing the concentration of Ge in the SiGe buffer layer **210** (for example of a further 5 ÷ 10 %) to compensate for the effect of the thermal stress. In this way, the buffer layer **210** would reduce the warping of the wafer, in addition to reduce defects.

The use of the alloy Si₁₋ₓGeₓ as a buffer layer allows to vary continuously and in a controlled manner the lattice pitch of the buffer layer, in order to accommodate, in a precise manner, the differences in lattice pitch existing between several innovative semiconductors such as SiC, GaN, diamond and the silicon (Si) substrate.

The reduction of the residual lattice mismatch results in a less residual stress maintained by the heterosystem, thus reducing the wafer bow of the entire heteroepitaxial wafer, so as to permit subsequent process steps (e.g., lithography, mechanical cleaning) typical of the planar technology commonly used for the production of electronic and/or optical and/or optoelectronic devices.

The reduction of the residual lattice mismatch also allows controlling and introduces stability in the misfit dislocations that are generated at the interface Epitaxy/Si₁₋ₓGeₓ. As a consequence, the transformation of misfit dislocations into the threading dislocations and stacking faults is reduced, thereby increasing the crystallographic quality of the epitaxial material.

The use of the silicon substrate allows radically reducing the production costs, obtaining higher crystalline quality (being the silicon substrate of high quality) and large size of the epitaxial layers.

The grown epitaxial film, having a low bow, high quality and large size, is ideal to be a seed for the subsequent growth of bulk ingots of up to 300 mm in diameter.

The present invention has been described herein with reference to some exemplary embodiments. Those skilled in the art, on the basis of the teachings provided herein, will be able to easily identify alternative embodiments, without departing from the scope of protection defined by the appended claims.

## Claims

1. Method for fabricating a semiconductor material wafer to be used for the integration of electronic and/or optical and/or optoelectronic devices, the method comprising:
- providing a starting wafer of crystalline silicon **(205);**
- on the starting wafer of crystalline silicon, epitaxially growing a buffer layer **(210)** formed of an alloy of silicon and germanium;
- epitaxially growing on the buffer layer a layer **(225)** of a semiconductor material having an energy gap larger than that of the crystalline silicon making up the starting wafer, wherein the layer of a semiconductor material having an energy gap larger than that of the crystalline silicon is grown up to have a thickness suitable for forming a substrate for the integration therein of electronic and/or optical and/or optoelectronic devices,
the method being **characterized by** comprising:
- before epitaxially growing on the buffer layer a layer (**225**) of a semiconductor material having an energy gap larger than that of the crystalline silicon, epitaxially growing on the buffer layer a cap layer of crystalline silicon (**220**).
wherein the cap layer (220) is a thin layer of strained silicon which adapts its own reticular pitch to that of the buffer layer below.

2. Method according to claim 1, wherein said semiconductor material having an energy gap larger than that of the crystalline silicon is a material selected from the group comprising silicon carbide, gallium nitride, diamond.

3. Method according to any of the preceding claims, wherein the concentration of germanium in the buffer layer is chosen as a function of the semiconductor material having an energy gap larger than that of the crystalline silicon and of the temperature of epitaxial growth of the layer of semiconductor material having an energy gap larger than that of the crystalline silicon.

4. Method according to claim 3 wherein the temperature of epitaxial growth of the layer of semiconductor material having an energy gap larger than that of the crystalline silicon is comprised between 300 °C and 1300 °C.

5. Method according to claim 4 when dependent from claim 2, wherein the concentration of germanium in the buffer layer is:
- comprised between 10 % and 30 % in the case the semiconductor material having an energy gap larger than that of the crystalline silicon is silicon carbide;
- comprised between 1 % and 17 % in the case the semiconductor material having an energy gap larger than that of the crystalline silicon is gallium nitride and a lattice matching of 6 cells of gallium nitride with 5 cells of silicon is desired to be achieved;
- comprised between 45 % and 63 % in the case the semiconductor material having an energy gap larger than that of the crystalline silicon is gallium nitride and a lattice matching of 11 cells of gallium nitride with 9 cells of silicon is desired to be achieved;
- comprised between 77 % and 93 % in the case the semiconductor material having an energy gap larger than that of the crystalline silicon is diamond and a lattice matching between 14 cells of diamond with 9 cells of silicon is desired to be achieved;
- comprised between 53 % and 69 % in the case the semiconductor material having an energy gap larger than that of the crystalline silicon is diamond and a lattice matching between 11 cells of diamond with 7 cells of silicon is desired to be achieved.

6. Method according to claim 5, wherein the thickness of the buffer layer is comprised between 0.1 µm and 10 µm.

7. Method according to any one of claims 4-6, wherein the thickness of the silicon cap layer is 10 nm or less.

8. Semiconductor material wafer to be used for the integration of electronic and/or optical and/or optoelectronic devices, comprising:
- a wafer of crystalline silicon **(205);**
- an epitaxial buffer layer **(210)** made of an alloy of silicon and germanium formed on the wafer of crystalline silicon;
- an epitaxial layer **(225)** of a semiconductor material having an energy gap larger than that of the crystalline silicon that forms the wafer of crystalline silicon, wherein the layer of semiconductor material having an energy gap larger than that of the crystalline silicon has a thickness suitable for making up a substrate for the integration therein of electronic and/or optical and/or optoelectronic devices.
**characterized by** comprising:
an epitaxially-grown cap layer of crystalline silicon (220) directly on the buffer layer (210) and directly below the epitaxial layer (225) of a semiconductor material having an energy gap larger than that of crystalline silicon, wherein the cap layer (220) is a thin layer of strained silicon which adapts its own reticular pitch to that of the buffer layer below.

9. Semiconductor material wafer according to claim 8, wherein the thickness of the buffer layer is comprised between 0.1 µm and 10 µm, and the concentration of germanium in the buffer layer is:
- comprised between 10 % and 30 % in the case the semiconductor material having an energy gap larger than that of the crystalline silicon is silicon carbide;
- comprised between 1 % and 17 % in the case the semiconductor material having an energy gap larger than that of the crystalline silicon is gallium nitride and a lattice matching of 6 cells of gallium nitride with 5 cells of silicon is achieved;
- comprised between 45 % and 63 % in the case the semiconductor material having an energy gap larger than that of the crystalline silicon is gallium nitride and a lattice matching of 11 cells of gallium nitride with 9 cells of silicon is achieved;
- comprised between 77 % and 93 % in the case the semiconductor material having an energy gap larger than that of the crystalline silicon is diamond and a lattice matching between 14 cells of diamond with 9 cells of silicon is achieved;
- comprised between 53 % and 69 % in the case the semiconductor material having an energy gap larger than that of the crystalline silicon is diamond and a lattice matching between 11 cells of diamond with 7 cells of silicon is achieved.

10. Semiconductor material wafer according to claim 9, wherein the concentration of germanium in the buffer layer, in the case the semiconductor material having an energy gap larger than that of the crystalline silicon is silicon carbide, is between 10 % and 25 %.

11. Semiconductor material wafer according to claim 9, wherein the concentration of germanium in the buffer layer, in the case the semiconductor material having an energy gap larger than that of the crystalline silicon is silicon carbide, is between 10 % and 20 %.

12. Semiconductor material wafer according to claim 9, wherein the concentration of germanium in the buffer layer, in the case the semiconductor material having an energy gap larger than that of the crystalline silicon is gallium nitride and a lattice matching of 6 cells of gallium nitride with 5 cells of silicon is achieved, is between 1% and 12 %.

13. Semiconductor material wafer according to claim 9, wherein the concentration of germanium in the buffer layer, in the case the semiconductor material having an energy gap larger than that of the crystalline silicon is gallium nitride and a lattice matching of 6 cells of gallium nitride with 5 cells of silicon is achieved, is between 1% and 7 %.

14. Semiconductor material wafer according to claim 9, wherein the concentration of germanium in the buffer layer, in the case the semiconductor material having an energy gap large than that of the crystalline silicon is gallium nitride and a lattice matching of 11 cells of gallium nitride with 9 cells of silicon is achieved, is between 45% and 58 %.

15. Semiconductor material wafer according to claim 9, wherein the concentration of germanium in the buffer layer, in the case the semiconductor material having an energy gap larger than that of the crystalline silicon is gallium nitride and a lattice matching of 11 cells of gallium nitride with 9 cells of silicon is achieved, is between 45% and 53 %.

16. Semiconductor material wafer according to claim 9, wherein the concentration of germanium in the buffer layer, in the case the semiconductor material having an energy gap larger than that of the crystalline silicon is diamond and a lattice matching between 14 cells of diamond with 9 cells of silicon is achieved, is between 77% and 88 %.

17. Semiconductor material wafer according to claim 9, wherein the concentration of germanium in the buffer layer, in the case the semiconductor material having an energy gap large than that of the crystalline silicon is diamond and a lattice matching between 14 cells of diamond with 9 cells of silicon is achieved, is between 77% and 83 %.

18. Semiconductor material wafer according to claim 9, wherein the concentration of germanium in the buffer layer, in the case the semiconductor material having an energy gap larger than that of the crystalline silicon is diamond and a lattice matching between 11 cells of diamond with 7 cells of silicon is achieved, is between 53% and 64%.

19. Semiconductor materials wafer according to claim 9, wherein the concentration of germanium in the buffer layer, in the case the semiconductor material having an energy gap larger than that of the crystalline silicon is diamond and a lattice matching between 11 cells of diamond with 7 cells of silicon is achieved, is between 53% and 59 %.

20. Semiconductor material wafer according to any one of claims 9 to 19, wherein the thickness of the buffer layer is comprised between 0.5 µm and 5 µm.

## Patentansprüche

1. Verfahren zur Herstellung eines Halbleitermaterialwafers, der für die Integration von elektronischen und/oder optischen und/oder optoelektronischen Bauelementen verwendet werden soll, wobei das Verfahren aufweist:
- Vorsehen eines Ausgangswafers aus kristallinem Silizium (205);
- epitaxiales Aufwachsen einer Pufferschicht (210), die aus einer Legierung aus Silizium und Germanium ausgebildet ist, auf dem Ausgangswafer aus kristallinem Silizium;
- epitaxiales Aufwachsen einer Schicht (225) aus einem Halbleitermaterial mit einer Energielücke, die größer ist als jene des kristallinen Siliziums, das den Ausgangswafer bildet, auf der Pufferschicht, wobei die Schicht aus einem Halbleitermaterial mit einer Energielücke, die größer ist als jene des kristallinen Siliziums, aufgewachsen wird, bis sie eine Dicke aufweist, die zum Ausbilden eines Substrats für die Integration von elektronischen und/oder optischen und/oder optoelektronischen Bauelementen darin geeignet ist,
wobei das Verfahren **dadurch gekennzeichnet ist, dass** es aufweist:
- epitaxiales Aufwachsen einer Deckschicht aus kristallinem Silizium (220) auf der Pufferschicht vor dem epitaxialen Aufwachsen einer Schicht (225) aus einem Halbleitermaterial mit einer Energielücke, die größer ist als jene des kristallinen Siliziums, auf der Pufferschicht ,
wobei die Deckschicht (220) eine dünne Schicht aus unter Spannung stehendem Silizium ist, die ihren eigenen netzartigen Abstand an jenen der Pufferschicht darunter anpasst.

2. Verfahren nach Anspruch 1, wobei das Halbleitermaterial, das eine Energielücke hat, die größer ist als jene des kristallinen Siliziums, ein Material ist, das aus der Gruppe ausgewählt ist, die Siliziumcarbid, Galliumnitrid, Diamant aufweist.

3. Verfahren nach irgendeinem der vorangehenden Ansprüche, wobei die Konzentration von Germanium in der Pufferschicht gewählt wird als Funktion des Halbleitermaterials mit einer Energielücke, die größer ist als jene des kristallinen Siliziums, und der Temperatur des epitaxialen Wachstums der Schicht aus Halbleitermaterial mit einer Energielücke, die größer ist als jene des kristallinen Siliziums.

4. Verfahren nach Anspruch 3, wobei die Temperatur des epitaxialen Wachstums der Schicht aus Halbleitermaterial mit einer Energielücke, die größer ist als jene des kristallinen Siliziums, zwischen 300 °C und 1300 °C liegt.

5. Verfahren nach Anspruch 4, wenn in Abhängigkeit von Anspruch 2, wobei die Konzentration von Germanium in der Pufferschicht:
- zwischen 10 % und 30 % liegt, falls das Halbleitermaterial mit einer Energielücke, die größer ist als jene des kristallinen Siliziums, Siliziumcarbid ist;
- zwischen 1 % und 17 % liegt, falls das Halbleitermaterial mit einer Energielücke, die größer ist als jene des kristallinen Siliziums, Galliumnitrid ist und es erwünscht ist, eine Gitteranpassung von 6 Zellen von Galliumnitrid an 5 Zellen von Silizium zu erreichen;
- zwischen 45 % und 63 % liegt, falls das Halbleitermaterial mit einer Energielücke, die größer ist als jene des kristallinen Siliziums, Galliumnitrid ist und es erwünscht ist, eine Gitteranpassung von 11 Zellen von Galliumnitrid an 9 Zellen von Silizium zu erreichen;
- zwischen 77 % und 93 % liegt, falls das Halbleitermaterial mit einer Energielücke, die größer ist als jene des kristallinen Siliziums, Diamant ist und es erwünscht ist, eine Gitteranpassung zwischen 14 Zellen von Diamant und 9 Zellen von Silizium zu erreichen;
- zwischen 53 % und 69 % liegt, falls das Halbleitermaterial mit einer Energielücke, die größer ist als jene des kristallinen Siliziums, Diamant ist und es erwünscht ist, eine Gitteranpassung zwischen 11 Zellen von Diamant und 7 Zellen von Silizium zu erreichen.

6. Verfahren nach Anspruch 5, wobei die Dicke der Pufferschicht zwischen 0,1 µm und 10 µm liegt.

7. Verfahren nach irgendeinem der Ansprüche 4-6, wobei die Dicke der Siliziumdeckschicht 10 nm oder weniger ist.

8. Halbleitermaterialwafer, der für die Integration von elektronischen und/oder optischen und/oder optoelektronischen Bauelementen verwendet werden soll, der aufweist:
- einen Wafer aus kristallinem Silizium (205);
- eine Epitaxiepufferschicht (210), die aus einer Legierung von Silizium und Germanium hergestellt ist, die auf dem Wafer aus kristallinem Silizium ausgebildet ist;
eine Epitaxieschicht (225) aus einem Halbleitermaterial mit einer Energielücke, die größer ist als jene des kristallinem Siliziums, das den Wafer aus kristallinem Silizium bildet, wobei die Schicht aus Halbleitermaterial mit einer Energielücke, die größer ist als jene des kristallinen Siliziums, eine Dicke aufweist, die zum Bilden eines Substrats für die Integration von elektronischen und/oder optischen und/oder optoelektronischen Bauelementen darin geeignet ist,
**dadurch gekennzeichnet, dass** er aufweist:
eine epitaxial aufgewachsene Deckschicht aus kristallinem Silizium (220) direkt auf der Pufferschicht (210) und direkt unter der Epitaxieschicht (225) aus einem Halbleitermaterial mit einer Energielücke, die größer ist als jene des kristallinen Siliziums, wobei die Deckschicht (220) eine dünne Schicht aus unter Spannung stehendem Silizium ist, die ihren eigenen netzartigen Abstand an jenen der Pufferschicht darunter anpasst.

9. Halbleitermaterialwafer nach Anspruch 8, wobei die Dicke der Pufferschicht zwischen 0,1 µm und 10 µm liegt, und die Konzentration von Germanium in der Pufferschicht:
- zwischen 10 % und 30 % liegt, falls das Halbleitermaterial mit einer Energielücke, die größer ist als jene des kristallinen Siliziums, Siliziumcarbid ist;
- zwischen 1 % und 17 % liegt, falls das Halbleitermaterial mit einer Energielücke, die größer ist als jene des kristallinen Siliziums, Galliumnitrid ist und eine Gitteranpassung von 6 Zellen von Galliumnitrid an 5 Zellen von Silizium erreicht wird;
- zwischen 45 % und 63 % liegt, falls das Halbleitermaterial mit einer Energielücke, die größer ist als jene des kristallinen Siliziums, Galliumnitrid ist und eine Gitteranpassung von 11 Zellen von Galliumnitrid an 9 Zellen von Silizium erreicht wird;
- zwischen 77 % und 93 % liegt, falls das Halbleitermaterial mit einer Energielücke, die größer ist als jene des kristallinen Siliziums, Diamant ist und eine Gitteranpassung zwischen 14 Zellen von Diamant und 9 Zellen von Silizium erreicht wird;
- zwischen 53 % und 69 % liegt, falls das Halbleitermaterial mit einer Energielücke, die größer ist als jene des kristallinen Siliziums, Diamant ist und eine Gitteranpassung zwischen 11 Zellen von Diamant und 7 Zellen von Silizium erreicht wird.

10. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Siliziumcarbid ist, zwischen 10 % und 25 % liegt.

11. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Siliziumcarbid ist, zwischen 10 % und 20 % liegt.

12. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Galliumnitrid ist und eine Gitteranpassung von 6 Zellen von Galliumnitrid an 5 Zellen von Silizium erreicht wird, zwischen 1 % und 12 % liegt.

13. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Galliumnitrid ist und eine Gitteranpassung von 6 Zellen von Galliumnitrid an 5 Zellen von Silizium erreicht wird, zwischen 1 % und 7 % liegt.

14. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Galliumnitrid ist und eine Gitteranpassung von 11 Zellen von Galliumnitrid an 9 Zellen von Silizium erreicht wird, zwischen 45 % und 58 % liegt.

15. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Galliumnitrid ist und eine Gitteranpassung von 11 Zellen von Galliumnitrid an 9 Zellen von Silizium erreicht wird, zwischen 45 % und 53 % liegt.

16. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Diamant ist und eine Gitteranpassung zwischen 14 Zellen von Diamant und 9 Zellen von Silizium erreicht wird, zwischen 77 % und 88 % liegt.

17. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Diamant ist und eine Gitteranpassung zwischen 14 Zellen von Diamant und 9 Zellen von Silizium erreicht wird, zwischen 77 % und 83 % liegt.

18. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Diamant ist und eine Gitteranpassung zwischen 11 Zellen von Diamant und 7 Zellen von Silizium erreicht wird, zwischen 53 % und 64 % liegt.

19. Halbleitermaterialwafer nach Anspruch 9, wobei die Konzentration von Germanium in der Pufferschicht, falls das Halbleitermaterial mit einer Energielücke, die größer ist als jene des kristallinen Siliziums, Diamant ist und eine Gitteranpassung zwischen 11 Zellen von Diamant und 7 Zellen von Silizium erreicht wird, zwischen 53 % und 59 % liegt.

20. Halbleitermaterialwafer nach irgendeinem der Ansprüche 9 bis 19, wobei die Dicke der Pufferschicht zwischen 0,5 µm und 5 µm liegt.

## Revendications

1. Procédé pour fabriquer une tranche de matériau semi-conducteur destinée à être utilisée pour l'intégration de dispositifs électroniques et/ou optiques et/ou optoélectroniques, le procédé comprenant :
- prévoir une tranche de départ en silicium cristallin (205) ;
- sur la tranche de départ en silicium cristallin, faire croître de façon épitaxiale une couche tampon (210) formée en un alliage de silicium et de germanium ;
- faire croître de façon épitaxiale sur la couche tampon une couche (225) d'un matériau semi-conducteur ayant une bande d'énergie interdite supérieure à celle du silicium cristallin qui constitue la tranche de départ, dans lequel la couche de matériau semi-conducteur ayant une bande d'énergie interdite supérieure à celle du silicium cristallin croit de façon à avoir une épaisseur appropriée pour former un substrat pour y intégrer des dispositifs électroniques et/ou optiques et/ou optoélectroniques,
le procédé étant **caractérisé en ce qu'**il comprend :
- avant de faire croître de façon épitaxiale sur la couche tampon une couche (225) d'un matériau semi-conducteur ayant une bande d'énergie interdite supérieure à celle du silicium cristallin, faire croître de façon épitaxiale sur la couche tampon une couche de couverture en silicium cristallin (220) ;
la couche de couverture (220) étant une couche mince en silicium contraint qui adapte son propre pas réticulaire à celui de la couche tampon située en dessous.

2. Procédé selon la revendication 1, dans lequel le matériau semi-conducteur ayant une bande d'énergie interdite supérieure à celle du silicium cristallin est un matériau sélectionné dans le groupe comprenant le carbure de silicium, le nitrure de gallium et le diamant.

3. Procédé selon l'une quelconque des revendications précédentes, dans lequel la concentration en germanium dans la couche tampon est choisie en fonction du matériau semi-conducteur ayant une bande d'énergie interdite supérieure à celle du silicium cristallin et de la température de la croissance épitaxiale de la couche de matériau semi-conducteur ayant une bande d'énergie interdite supérieure à celle du silicium cristallin.

4. Procédé selon la revendication 3, dans lequel la température de la croissance épitaxiale de la couche de matériau semi-conducteur ayant une bande d'énergie interdite supérieure à celle du silicium cristallin est comprise entre 300 °C et 1300 °C.

5. Procédé selon la revendication 4, dans sa dépendance de la revendication 2, dans lequel la concentration en germanium dans la couche tampon est :
- comprise entre 10 % et 30 % dans le cas où le matériau semi-conducteur ayant une bande d'énergie interdite supérieure à celle du silicium cristallin est du carbure de silicium ;
- comprise entre 1 % et 17 % dans le cas où le matériau semi-conducteur ayant une bande d'énergie interdite supérieure à celle du silicium cristallin est du nitrure de gallium et où on souhaite obtenir une correspondance de réseau de 6 cellules de nitrure de gallium avec 5 cellules de silicium ;
- comprise entre 45 % et 63 % dans le cas où le matériau semi-conducteur ayant une bande d'énergie interdite supérieure à celle du silicium cristallin est du nitrure de gallium et où on souhaite obtenir une correspondance de réseau de 11 cellules de nitrure de gallium avec 9 cellules de silicium ;
- comprise entre 77 % et 93 % dans le cas où le matériau semi-conducteur ayant une bande d'énergie interdite supérieure à celle du silicium cristallin est du diamant et où on souhaite obtenir une correspondance de réseau entre 14 cellules de diamant et 9 cellules de silicium ;
- comprise entre 53 % et 69 % dans le cas où le matériau semi-conducteur ayant une bande d'énergie interdite supérieure à celle du silicium cristallin est du diamant et où on souhaite obtenir une correspondance de réseau entre 11 cellules de diamant et 7 cellules de silicium.

6. Procédé selon la revendication 5, dans lequel l'épaisseur de la couche tampon est comprise entre 0,1 *µ*m et 10 *µ*m.

7. Procédé selon l'une quelconque des revendications 4 à 6, dans lequel l'épaisseur de la couche de couverture en silicium est inférieure ou égale à 10 nm.

8. Tranche de matériau semi-conducteur destinée à être utilisée pour l'intégration de dispositifs électroniques et/ou optiques et/ou optoélectroniques, comprenant :
- une tranche de silicium cristallin (205) ;
- une couche tampon épitaxiale (210) en un alliage de silicium et de germanium, formée sur la tranche de silicium cristallin ;
- une couche épitaxiale (225) en un matériau semi-conducteur ayant une bande d'énergie interdite supérieure à celle du silicium cristallin qui forme la tranche de silicium cristallin, dans laquelle la couche de matériau semi-conducteur ayant une bande d'énergie interdite supérieure à celle du silicium cristallin a une épaisseur appropriée pour constituer un substrat pour y intégrer des dispositifs électroniques et/ou optiques et/ou optoélectroniques ;
**caractérisé en ce qu'**elle comprend :
une couche de couverture obtenue par croissance épitaxiale de silicium cristallin (220) directement sur la couche tampon (210) et directement en dessous de la couche épitaxiale (225) d'un matériau semi-conducteur ayant une bande d'énergie interdite supérieure à celle du silicium cristallin, la couche de couverture (220) étant une couche mince de silicium contraint qui adapte son propre pas réticulaire à celui de la couche tampon située en dessous.

9. Tranche de matériau semi-conducteur selon la revendication 8, dans laquelle l'épaisseur de la couche tampon est comprise entre 0,1 *µ*m et 10 *µ*m, et la concentration en germanium dans la couche tampon est :
- comprise entre 10 % et 30 % dans le cas où le matériau semi-conducteur ayant une bande d'énergie interdite supérieure à celle du silicium cristallin est du carbure de silicium ;
- comprise entre 1 % et 17 % dans le cas où le matériau semi-conducteur ayant une bande d'énergie interdite supérieure à celle du silicium cristallin est du nitrure de gallium et où on obtient une correspondance de réseau de 6 cellules de nitrure de gallium avec 5 cellules de silicium ;
- comprise entre 45 % et 63 % dans le cas où le matériau semi-conducteur ayant une bande d'énergie interdite supérieure à celle du silicium cristallin est du nitrure de gallium et où on obtient une correspondance de réseau de 11 cellules de nitrure de gallium avec 9 cellules de silicium ;
- comprise entre 77 % et 93 % dans le cas où le matériau semi-conducteur ayant une bande d'énergie interdite supérieure à celle du silicium cristallin est du diamant et où on obtient une correspondance de réseau entre 14 cellules de diamant et 9 cellules de silicium ;
- comprise entre 53 % et 69 % dans le cas où le matériau semi-conducteur ayant une bande d'énergie interdite supérieure à celle du silicium cristallin est du diamant et où on obtient une correspondance de réseau entre 11 cellules de diamant et 7 cellules de silicium.

10. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du carbure de silicium, est comprise entre 10 % et 25 %.

11. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du carbure de silicium, est comprise entre 10 % et 20 %.

12. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du nitrure de gallium et où on obtient une correspondance de réseau de 6 cellules de nitrure de gallium avec 5 cellules de silicium, est comprise entre 1 % et 12 %.

13. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du nitrure de gallium et où on obtient une correspondance de réseau de 6 cellules de nitrure de gallium avec 5 cellules de silicium, est comprise entre 1 % et 7 %.

14. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du nitrure de gallium et où on obtient une correspondance de réseau de 11 cellules de nitrure de gallium avec 9 cellules de silicium, est comprise entre 45 % et 58 %.

15. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du nitrure de gallium et où on obtient une correspondance de réseau de 11 cellules de nitrure de gallium avec 9 cellules de silicium, est comprise entre 45 % et 53 %.

16. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du diamant et où on obtient une correspondance de réseau de 14 cellules de diamant avec 9 cellules de silicium, est comprise entre 77 % et 88 %.

17. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du diamant et où on obtient une correspondance de réseau de 14 cellules de diamant avec 9 cellules de silicium, est comprise entre 77 % et 83 %.

18. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du diamant et où on obtient une correspondance de réseau de 11 cellules de diamant avec 7 cellules de silicium, est comprise entre 53 % et 64 %.

19. Tranche de matériau semi-conducteur selon la revendication 9, dans laquelle la concentration en germanium dans la couche tampon, dans le cas où le matériau semi-conducteur ayant une bande d'énergie interdite supérieure à celle du silicium cristallin est du diamant et où on obtient une correspondance de réseau de 11 cellules de diamant avec 7 cellules de silicium, est comprise entre 53 % et 59 %.

20. Tranche de matériau semi-conducteur selon l'une quelconque des revendications 9 à 19, dans laquelle l'épaisseur de la couche tampon est comprise entre 0,5 *µ*m et 5 *µ*m.
